Europäisches Patentamt

European Patent Office

Office européen des brevets

(11) Publication number : **0 485 233 A2**

(12) **EUROPEAN PATENT APPLICATION**

(21) Application number : **91310362.8**

(22) Date of filing : **08.11.91**

(51) Int. Cl.$^5$ : **H01L 21/336**

(30) Priority : **09.11.90 JP 305528/90**
**09.11.90 JP 305529/90**

(43) Date of publication of application :
**13.05.92 Bulletin 92/20**

(84) Designated Contracting States :
**DE FR GB**

(71) Applicant : **SEL SEMICONDUCTOR ENERGY**
**LABORATORY CO., LTD.**
**398 Hase**
**Atsugi-shi Kanagawa-ken 243 (JP)**

(72) Inventor : **Yamazaki, Shunpei**
**21-21, Kitakarasuyama, 7-chome**
**Setagaya-ku, Tokyo 157 (JP)**
Inventor : **Zhang, Hongyong**
**302, 1-10-15, Fukamidai**
**Yamato-shi, Kanagawa-ken 242 (JP)**
Inventor : **Inushima, Takashi**
**1-29-2-204, Morinosato**
**Atsugi-shi, Kanagawa-ken 243-01 (JP)**
Inventor : **Fukada, Takeshi**
**2589-3-31, Sugikubo**
**Ebina-shi, Kanagawa-ken 243-04 (JP)**

(74) Representative : **Milhench, Howard Leslie et al**
**R.G.C. Jenkins & Co. 26 Caxton Street**
**London SW1H 0RJ (GB)**

(54) **A method of manufacturing insulated-gate field effect transistors.**

(57) A method of manufacturing thin film field effect transistors is described. The channel region of the transistors is formed by depositing an amorphous semiconductor film in a first sputtering apparatus followed by thermal treatment for converting the amorphous phase to a polycrystalline phase. The gate insulating film is formed by depositing an oxide film in a second sputtering apparatus connected to the first apparatus through a gate valve. The sputtering for the deposition of the amorphous semiconductor film is carried out in an atmosphere comprising hydrogen in order to introduce hydrogen into the amorphous semiconductor film. The gate insulating oxide film is deposited by sputtering in an atmosphere comprising oxygen.

EP 0 485 233 A2

## BACKGROUND OF THE INVENTION

### 1. Field of the Invention

The present invention relates generally to a method of manufacturing semiconductor devices and, more particularly though not exclusively, to a method of manufacturing thin-film gate insulated field effect transistors incorporating polycrystalline semiconductor films.

### 2. Description of the Prior Art

The prior art includes methods utilizing low-pressure CVD by which polycrystalline semiconductor thin films are deposited at temperatures ranging from 550°C to 900°C. Recently, with the development of liquid crystal panels having larger display areas, there has been an associated need for a deposition technique that can coat polycrystalline semiconductor films over large area substrates.

The direct deposition of polycrystalline films over large areas of substrate is difficult because of the high reaction temperature requirement. Instead, polycrystalline films are formed by depositing amorphous semiconductor films using low-pressure CVD and then recrystallizing the amorphous films. However, this method is not ideal because, it is very difficult to deposit uniform semiconductor films by low-pressure CVD. This problem is also associated with plasma CVD which additionally requires longer deposition times.

Sputtering on the other hand is of great value for this application and magnetron sputtering in particular, has the following advantages:

1) the surfaces of substrates are not damaged by high energy electrons since the electrons are confined to the vicinity of the target;

2) wide areas can be coated at lower temperatures;

3) no dangerous gas is used so that safety and ease of use are ensured.

However, it must be noted that conventional sputtering is carried out without hydrogen doping because the electric characteristics of hydrogenated amorphous semiconductors deposited by sputtering do not satisfy the requirements of channel formation for transistors. Furthermore, thermal crystallisation of semiconductor films deposited by hydrogen-free sputtering is very difficult.

## OBJECTS AND SUMMARY OF THE INVENTION

It is an object of the present invention to provide a method of manufacturing gate insulated field effect transistors incorporating polycrystalline semiconductor films in which the barrier heights of grain boundaries are substantially reduced.

It is another object of the present invention to provide a method of manufacturing gate insulated field effect transistors incorporating polycrystalline semiconductor films formed over a large area substrate.

It is a further object of the present invention to provide a method of manufacturing gate insulated field effect transistors incorporating polycrystalline semiconductor films which are so dense that natural oxides cannot readily form within the films.

It is a still further object of the present invention to provide a method of manufacturing gate insulated field effect transistors incorporating polycrystalline semiconductor films which possess lattice distortion.

To achieve the foregoing and other objects, the present invention in one of its aspects proposes that a semiconductor film intended to form a channel region is deposited on a substrate by sputtering in an atmosphere comprising hydrogen, and that an oxide film intended to form a gate insulating film is deposited by sputtering in an atmosphere comprising oxygen. Furthermore, the invention proposes that the semiconductor film and the oxide film are deposited on the substrate one after the other in separate sputtering apparatuses arranged to prevent cross-contamination between the two apparatuses, that is to say to prevent oxygen from the sputtering apparatus used for deposition of the oxide film from leaking into the other sputtering apparatus used for deposition of the semiconductor film and similarly to prevent contamination in the opposite direction irrespective of which film is first deposited, the density of oxygen atoms occurring in the semiconductor film is limited to no greater than $7 \times 10^{19} cm^{-3}$, and preferably no greater than $1 \times 10^{19} cm^{-3}$.

In order to obtain an insulated-gate field effect transistor having high performance, two or more kinds of layers constituting the transistor may be deposited by sputtering in individual sputtering apparatuses. Two or more of the sputtering apparatuses may be connected so that transportation of a substrate of the transistor can be performed without exposing the substrate and layers formed thereon to the air. To achieve this, gate valves or subsidiary chambers may for example be provided between the sputtering apparatuses. If the sputtering apparatuses are arranged in series, insulated-gate field effect transistors having two or more layers can be formed on an assembly line basis by the use of such serially arranged apparatuses so that productivity can be maximized.

In accordance with a preferred embodiment of the present invention, the semiconductor film is first deposited in an amorphous state or an equivalent state. The amorphous semiconductor is then given thermal treatment at 450°C to 700°C (typically 600°C) in order to convert the amorphous state to a polycrystalline state in at least the channel region of the transistor. Instead of thermal treatment, the amorphous semiconductor may be irradiated with a beam emitted from a light source, for example a laser or a halogen lamp in order to convert the amorphous phase to a polycrystalline phase at least in the channel region. This recrystallization takes place easily as compared to the conventional case in which no hydrogen is introduced, as explained supra. This is considered to be because of the following reason. In the conventional case where no hydrogen is introduced, amorphous semiconductors such as a-Si are deposited to form a certain type of microstructure in which the distribution of silicon atoms is uneven and this microstructure hinders the process of recrystallization during thermal treatment or irradiation with a light source. The inventors of the present invention have confirmed that the formation of such a microstructure is prevented by introducing hydrogen into the semiconductor film which then can be easily recrystallized by thermal treatment or irradiation with a beam emitted from a light source. The average diameter of polycrystals formed after recrystallisation in accordance with the present invention is of the order of 5Å to 400Å, typically 50Å to 200Å. Such a small size of grain in the polycrystals is particularly effective in preventing reverse current leakage across $N^+$-I and $P^+$-I junctions. The proportion of hydrogen introduced into the film is no greater than 5 atom%.

Another important feature of the semiconductor film produced in accordance with the present invention is lattice distortion which enables close connection between polycrystals at interfaces thereof. This feature helps to lessen discontinuities and hinders the formation of barriers at the polycrystal interfaces; in the absence of such lattice distortions, impurity atoms such as oxygen would tend to collect at the interfaces and form crystal barriers which would hinder the transportation of carriers. In addition, since the oxygen density in the semiconductor film is no higher than $7 \times 10^{19} cm^{-3}$ in accordance with the present invention, potential barriers are substantially not formed. Such low oxygen density can be realized by carrying out the deposition of oxide films and semiconductor films in separate chambers provided for exclusive use in depositing the respective films. The oxygen density can be further decreased by evacuating the inside of the chamber to a very high vacuum condition, in advance of deposition, by means of a combination of a turbomolecular pump and a cryosorption pump. Because of this, the mobility (field mobility) of electrons in semiconductors formed in accordance with the present invention is improved as much as 50 to 300 $cm^2/V\cdot S$.

Furthermore, the semiconductor film deposited by sputtering in accordance with the invention is so fine and dense as not to allow oxidation to penetrate to the inside of the film and only a very thin oxide film is formed at the surface thereof. A semiconductor film deposited by plasma CVD includes a relatively high proportion of its amorphous state which allows oxidation to occur, reaching the inside of the semiconductor film. The fine structure of the semiconductor film formed in accordance with the present invention also helps to reduce interfacial barriers between crystals in association with lattice distortion.

The atmosphere in which sputtering for the deposition of the semiconductor film is carried out may be hydrogen, a mixture of hydrogen and an inert gas such as Ar and He, or a hydrogen compound which does not change the property of the semiconductor film such as $SiH_4$ or $Si_2H_6$. Irrespective of the nature of the hydrogen constituent the density of hydrogen in the atmosphere controls the amount of hydrogen absorbed by the semiconductor film which has to be of an order sufficient to cause lattice distortion therein. In the case of hydrogen-/argon mixtures, the hydrogen proportion is generally selected to be between 5% and 100% (therefore the argon proportion is between 95% and 0%), is typically between 10% and 99% (the argon proportion being between 90% and 1%), and desirably is between 25% and 95% (the argon proportion being between 75% and 5%).

In accordance with preferred embodiments, an oxide film forming a gate insulating film and a semiconductor film forming a channel region are deposited successively so that the electrical characteristics of the gate insulated field effect transistor formed from the films become stable without being influenced from external disturbances. Of course, the present invention can be applied to a variety of types of transistors such as staggered types, coplanar types, inverted staggered types and inverted coplanar types.

The above and further features of the present invention are set forth with particularity in the appended claims and will become clear to those possessed of appropriate knowledge and skills from consideration of the following description given with reference to the accompanying drawings.

BRIEF DESCRIPTION OF THE DRAWINGS

Fig. 1 is a schematic view showing a system for manufacturing thin-film field effect semiconductor transistors in accordance with a first embodiment of the present invention;

3

Fig.2(A) is a schematic cross-sectional view showing a planar type of magnetron RF sputtering apparatus suitable for use in the system illustrated in Fig.1 for depositing oxide or semiconductor films;

Fig.2(B) is an explanatory view showing the arrangement of magnets provided in the apparatus illustrated in Fig.2(A);

Figs.3(A) to 3(D) are cross-sectional views showing a method of manufacturing thin-film field effect semiconductor transistors in accordance with the first embodiment of the present invention;

Fig. 4 is a graphical diagram showing the relationship between the partial pressure of hydrogen in the atmosphere in which the semiconductor films are deposited and the field mobility of the resultant semiconductor film;

Fig. 5 is a graphical diagram showing the relationship between the partial pressure of hydrogen in the atmosphere in which semiconductor films are deposited, and the threshold voltage of the transistor formed from the resultant semiconductor film;

Fig. 6 is a graphical diagram showing the Raman spectra of the semiconductor films deposited under several deposition conditions;

Fig. 7 is a schematic view showing a system for manufacturing thin-film field effect semiconductor transistors in accordance with a second embodiment of the present invention;

Fig. 8 is a cross-sectional view showing a method of manufacturing thin-film field effect semiconductor transistors in accordance with the second embodiment of the present invention;

Fig. 9 is a schematic view showing a system for manufacturing thin-film field effect semiconductor transistors in accordance with a third embodiment of the present invention;

Figs 10(A) to 10(E) are cross-sectional views showing a method of manufacturing thin-film field effect semiconductor transistors in accordance with the third embodiment of the present invention, and

Figs. 11(A) and 11(B) are cross-sectional views showing thin-film field effect transistors in accordance with the present invention.

## DETAILED DESCRIPTION OF THE EMBODIMENTS

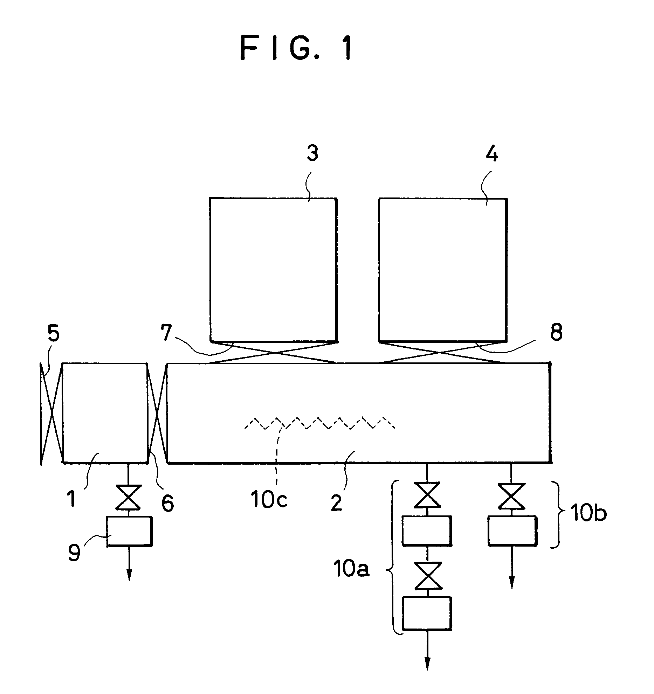

Referring now to Fig. 1, Figs.2(A) and 2(B) and Figs. 3(A) to 3(D), a method of manufacturing insulated-gate field effect transistors will now be explained. Fig. 1 is a schematic view showing a multi-chamber sputtering system for depositing semiconductor and gate insulation films by magnetron RF sputtering in accordance with a first embodiment of the present invention. The system comprises a loading and unloading chamber 1 provided with a gate valve 5, a subsidiary chamber 2 connected to the loading and unloading chamber 1 via a gate valve 6, and first and second individual sputtering apparatuses 3 and 4 respectively, connected to the subsidiary chamber 2 through gate valves 7 and 8 respectively. The loading and unloading chamber 1 is provided with an evacuation system 9 comprising a rotary pump and a turbomolecular pump coupled in series. The subsidiary chamber 2 is provided with a first evacuation system 10a for roughing comprising a rotary pump and a turbomolecular pump in series, a second evacuation system 10b for high vacuum evacuation comprising a cryosorption pump, and a heater 10c located in the subsidiary chamber 2 in order to heat the substrates to be coated. If glass substrates to be coated are thermally stabilized in advance by being heated in the subsidiary chamber 2, then thermal distortion and stress caused in films during deposition can be reduced thereby improving the adhesion of the films to the substrates.

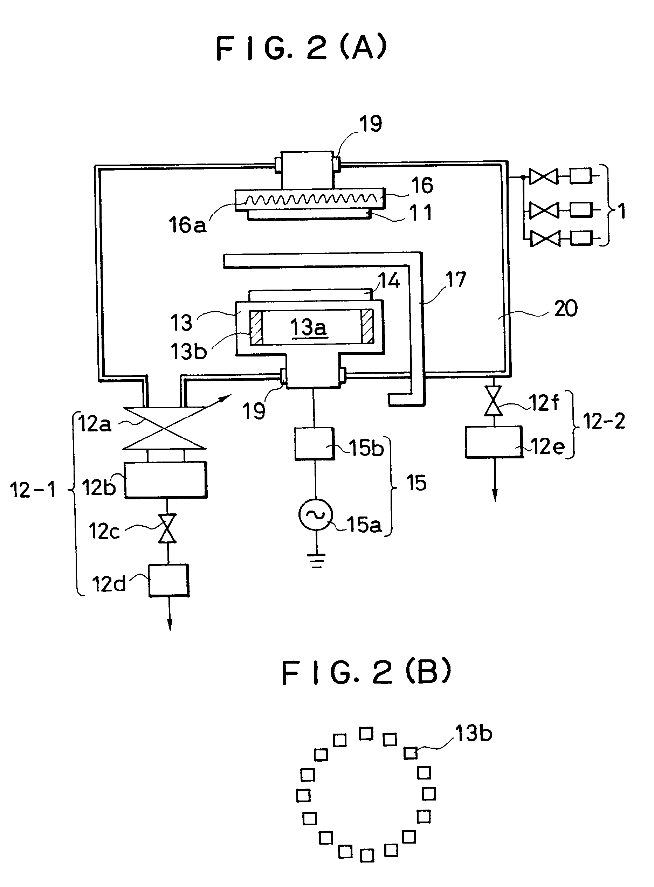

The sputtering apparatuses 3 and 4 are individual planar type magnetron RF sputtering apparatuses suitable for exclusive use in depositing gate insulating films and semiconductor films respectively when used in accordance with the present invention. Figs. 2(A) and 2(B) illustrate details of the RF sputtering apparatus. The apparatus comprises a vacuum chamber 20, a first evacuation system 12-1 for roughing consisting of a turbomolecular pump 12b and a rotary pump 12d provided with valves 12a and 12c respectively, a second evacuation system 12-2 for high vacuum evacuation comprising a cryosorption pump 12e provided with a valve 12f, a metallic holder 13 fixed in the lower section of the vacuum chamber 20 for supporting a target 14 thereon the holder being formed with an inner conduit 13a through which a coolant can be caused to flow to cool the target 14 and being provided with a plurality of magnets 13b such as electromagnets, an energy supply 15 consisting of an RF (e.g. 13.56 MHz) source 15a provided with a matching box 15b for supplying RF energy to the holder 13, a substrate holder 16 located in the upper section of the vacuum chamber 20 for supporting a substrate 11 to be coated, a heater 16a embedded in the substrate holder 16, a shutter system 17 located between the substrate 11 and the target 14, and a gas supply system 18. A sealing means 19 is also provided for ensuring that the vacuum chamber 20 remains airtight. In advance of actual deposition on the substrate 11, impurities occurring in the targets are sputtered out and deposited on the shutter 17 which is positioned between the substrate 11 and the target 14, and then the shutter is removed in order to enable normal deposition to be effected on the substrate 11. The magnets 13b are oriented with their N poles at their upper ends and their S poles at their lower ends and are horizontally arranged in a circle as illustrated in Fig.2(B) in order to confine electrons within a sputtering region between the substrate 11 and the target 14.

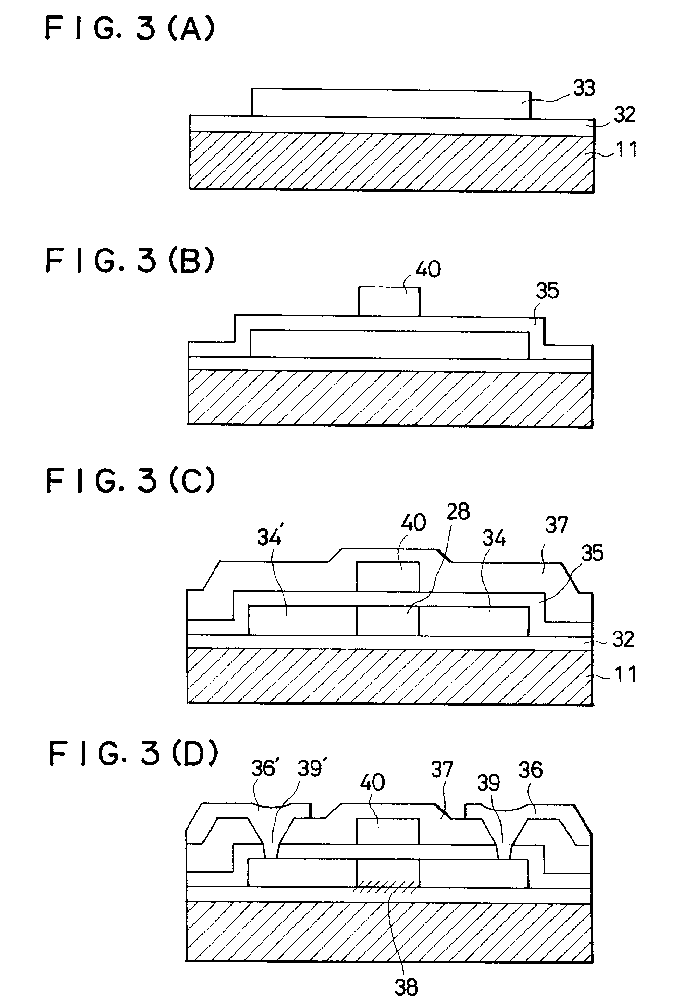

Referring now to Figs.3(A) to 3(D) together with Fig.1 and Figs.2(A) and 2(B), a method of manufacturing thin-film field effect transistors in accordance with a first preferred embodiment of the invention will now be described in detail. Ten sheets of glass substrate are mounted on a cassette and placed in the loading and unloading chamber 1 through the gate valve 5. After adjusting the pressures and inner atmospheres of the loading and unloading chamber 1 and the subsidiary chamber 2 to be equivalent, the cassette is transported from the loading and unloading chamber 1 into the subsidiary chamber 2 through the valve 6. One of the glass substrates is positioned in the first magnetron RF sputtering apparatus as shown in Fig.2(A) by means of a transportation mechanism (not shown) and coated with a $SiO_2$ film 32 therein to a thickness of 200nm. The conditions under which this deposition is carried out are given as: an atmosphere of 100% oxygen; a total atmospheric pressure of 0.5 PA; a substrate temperature of 150°c; and a power output of 400W from the 13.56 MHz RF apparatus. The target is composed of an artificial quartz or a high purity silicon having a purity of 99.999% or more, for example a single crystalline silicon or a polycrystalline silicon. The coated substrate is then exchanged for one of the remaining substrates and this is subsequently coated with a $SiO_2$ film in the same manner. The process is repeated until all the substrates mounted on the cassette are coated with a $SiO_2$ film. During this procedure, the transportation of a substrate between the chamber 2 and the sputtering apparatus 3 has to be carried out after adjusting the pressures and the inner atmospheres of the chambers 2 and 3 to be equivalent, so as to eliminate possible corruption by undesirable impurities. This procedure is generally employed when it is desired to transport the substrates between any two adjacent chambers, even if not particularly described hereinbelow.

An amorphous silicon film 33 is next deposited in the second sputtering apparatus 4 on the $SiO_2$ film 32 to a thickness of 100 nm. The 10 substrates are placed into the second sputtering apparatus 4 one after another from the subsidiary chamber 2 in the same manner as described previously and an amorphous silicon film is deposited on each substrate. The transportation of each substrate between the apparatus 4 and the subsidiary chamber 2 is carried out after adjusting the pressures and the inner atmospheres of the chamber 2 and 4 in order to eliminate undesirable impurities. The atmosphere in the second sputtering apparatus 4 comprises a mixture consisting of hydrogen and argon so that the partial pressure of hydrogen is given as $H_2/(H_2+Ar) = 0.8$. The hydrogen and argon gases have purities of 99.999% and 99.99% respectively and are introduced after the inside of the second sputtering apparatus 4 is evacuated to a pressure of $1 \times 10^{-7}$ Pa. The deposition is carried out under a total atmospheric pressure of 0.5 Pa with the output power of the 13.56MHz RF apparatus at 400W using a target composed of single crystalline silicon containing oxygen atoms at a concentration of no greater than $5 \times 10^{18}$cm$^{-3}$ (typically $1 \times 10^{18}$cm$^{-3}$), and with the substrate temperature (deposition temperature) maintained at 150°C by use of the heater 16a. In the preferred embodiments, the hydrogen proportion in the mixture may be chosen to be between 5% and 100%, the deposition temperature between 50°C and 500°C and the output power of the RF apparatus between 1W and 10MW in a frequency range from 500Hz to 100GHz which in addition may be combined with another pulsed energy source.

After all the substrates are coated with the silicon oxide and amorphous silicon semiconductor films, thermal treatment is given thereto in the subsidiary chamber 2 by means of the heater 10c at an operating temperature in the range 450°C to 700°C (typically 600°C) for a period of 10 hours using an atmosphere of hydrogen or an inert gas, e.g. 100% nitrogen. The film is recrystallized by this treatment (thermal annealing) and forms a semi-amorphous or semi-crystalline structure. It was confirmed by SIMS (secondary ion mass spectroscopy analysis) that oxygen, carbon and hydrogen impurities were present in this structure at densities of $8 \times 10^{18}$cm$^{-3}$, $3 \times 10^{10}$cm$^{-3}$ and $4 \times 10^{20}$cm$^{-3}$ respectively, which are in total equivalent to one atom % assuming the density of silicon being $4 \times 10^{22}$cm$^{-3}$. These density figures were minimum values for the respective elements and varied along the depth direction. The reason why these minimum values were used is because a natural oxide existed at the surface of the semiconductor film. The evaluation of these densities should therefore be made with reference to the oxygen density in the silicon target ($1 \times 10^{18}$cm$^{-3}$).

These impurity densities were not changed even after the recrystallization so that the oxygen density remained at $8 \times 10^{18}$cm$^{-3}$. The formation of amorphous silicon films was repeated for reference by the introduction of $N_2O$ with the reactive gas at 2 rates: 0.1 cc/sec and 1 cc/sec. As a result, the oxygen densities after recrystallization increased to $1 \times 10^{20}$cm$^{-3}$ and $4 \times 10^{20}$cm$^{-3}$ respectively. In these cases, the temperature during thermal annealing must be elevated beyond 700°C or the time of thermal treatment must be increased by a factor of 5 to perform sufficient recrystallization. Such high temperatures cannot be employed in practice because of the low softening temperature of glass substrates. Also, long process times are undesirable from the viewpoint of mass-production. From these facts, it will be understood that it is an important advantage of the present invention that the substrate temperature is limited to no higher than 700°C, and typically no higher than 600°C. The recrystallization of amorphous silicon semiconductor films became impossible, however, when the thermal annealing was carried out at a temperature no higher than 450°C or the oxygen density in the amorphous silicon semiconductor films reached $1 \times 10^{20}$cm$^{-3}$ or higher due to oxygen leakage into the system. Therefore, the oxygen density in the semiconductor films and the temperature range of thermal annealing have to be no higher than $7 \times 10^{19}$cm$^{-3}$ and in the range of 450°C to 700°C respectively.

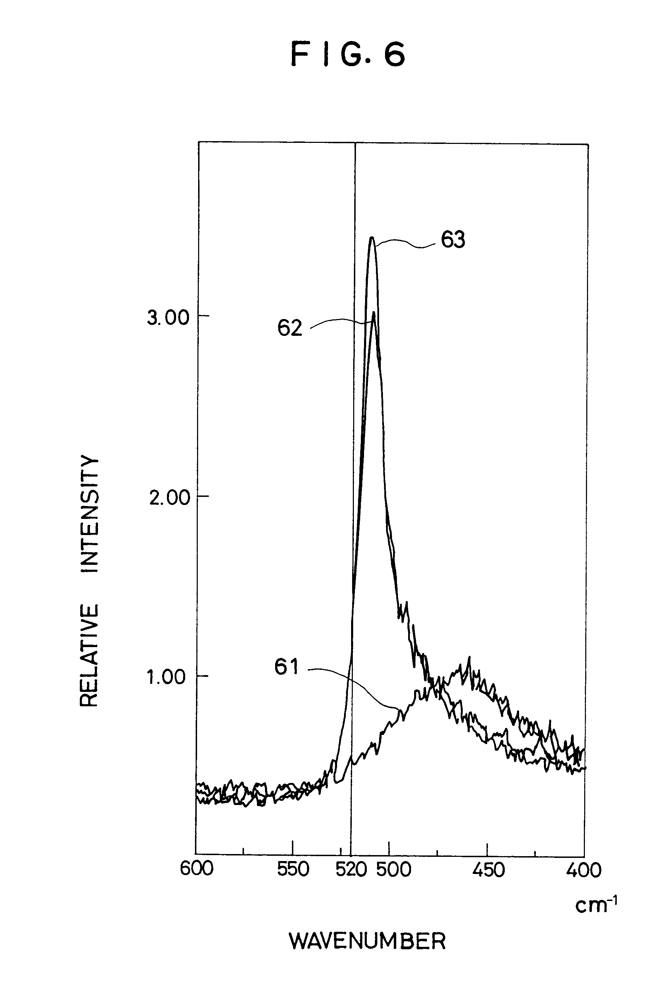

The impurities such as oxygen usually tend to be collected at the interfaces between crystals and form interfacial barriers in the semiconductors. In the case of the semiconductor film formed according to the present invention, however, lattice distortion prevents the formation of these barriers. The existence of lattice distortion has been indicated by a shift in a peak of the corresponding laser Raman spectra toward the lower frequency direction as shown in Fig.6, which will be explained later.

After the recrystallization, the substrates are removed from the system. The semiconductor film of each substrate is etched in a suitable etching apparatus to produce a pattern necessary to form a number of transistors on the substrate 11 in accordance with the following procedure. The film 33 shown in Fig. 3(A) corresponds to one of the transistors to be formed.

The substrates are then placed in the manufacturing system again and this is followed by hydrogen plasma cleaning of the surfaces of each of the semiconductor films 33 in the first sputtering apparatus 3. The entire structure of each is then coated with a 100 nm thick silicon oxide film 35 by sputtering in an oxide atmosphere as illustrated in Fig. 3(B). The conditions under which deposition is carried out are given as: an atmosphere comprising a high density of oxygen (95%) including NF$_3$ (5%) at a total atmospheric pressure of 0.5 Pa; a power output of 400w from the 13.56 MHz RF apparatus; a target composed of an artificial quartz or a high purity silicon having a purity of 99.999% or more, for example a single crystalline silicon or a polycrystalline silicon; and a substrate temperature of 100°C. It is possible for the mixture of oxygen and NF$_3$ to be replaced by a mixture of an inert gas and oxygen or the surface level density to be reduced by increasing the proportion of oxygen to 100% (preferably pure oxygen) so as to obtain excellent transistor characteristics. However, by using the O$_2$ and NF$_3$ composition, the silicon oxide film 35 which constitutes the gate insulating film includes fluorine atoms which function to terminate open ended or dangling bonds of some silicon atoms so that the formation of fixed charge can be prevented at the interface between the semiconductor film 33 and the oxide film 35. A silicon semiconductor film which is highly doped with phosphorus is deposited by a low-pressure CVD on the silicon oxide film 35 and this is followed by photolithography with a suitable mask in order to form a gate electrode 40.

Using this mask or with the gate electrode 40 used as a mask, self-aligned impurity regions, i.e. a source and a drain region 34 and 34' are formed by ion implantation. The resultant intermediate region 28 of the silicon semiconductor film 33 between the impurity regions 34 and 34' is then defined as a channel region as illustrated in Fig. 3(C). The channel region is subsequently thermally annealed at a temperature in the range 100°C to 500°C, for example 300°C, for 0.1 hour to 3 hours, for example 1 hour, in an atmosphere of hydrogen. The resultant interface state density is not more than $2 \times 10^{11}$ cm$^{-3}$. An interlayer insulation film 37 is coated over the entire surface of the structure followed by etching for opening contact holes through the interlayer insulation film 37 and the oxide film 35 in order to provide access to the underlying source and drain regions 34 and 34'. Finally, an aluminum film is deposited on the structure over the contact holes and is patterned to form source and drain electrodes 36 and 36' as illustrated in Fig. 3(D). In accordance with this embodiment, since the source and drain regions and the channel region are formed in the same semiconductor film 33 so the process of manufacture can be simplified and the carrier mobility in the source and drain regions is improved because of the crystallinity of the semiconductor film 33. Since the semiconductor film 33 is deposited on the underlying silicon oxide film 32 by sputtering, the bottom surface of the semiconductor film 33 is partially oxidized to form SiO$_x$ at the interface therebetween as designated by numeral 38 in Fig. 3(D). The SiO$_x$ functions to prevent formation of a back channel effect and reverse current leakage thereacross, and therefore is very effective and appropriate for manufacture of CMOS technology.

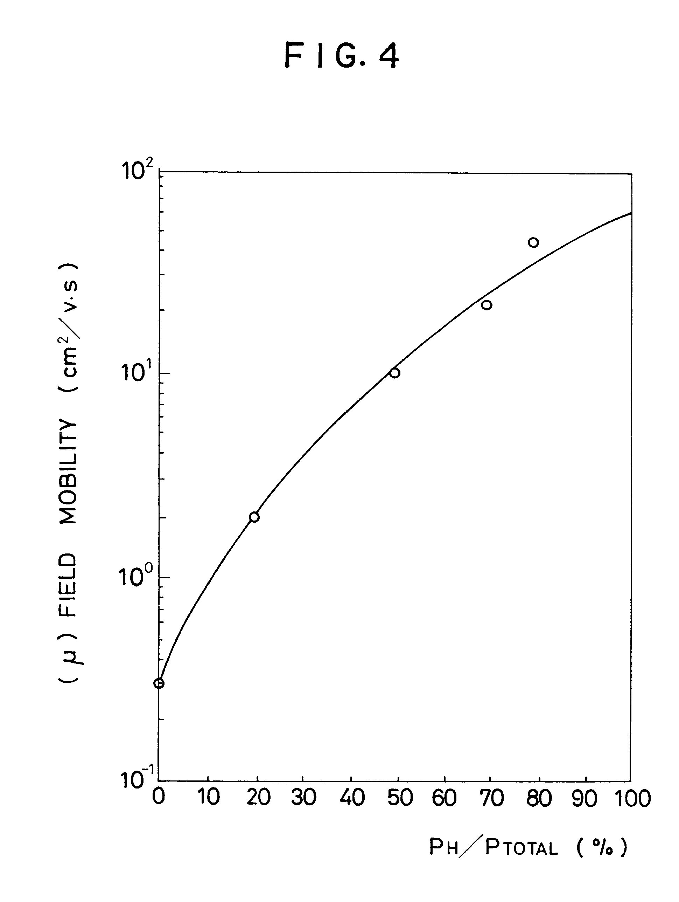

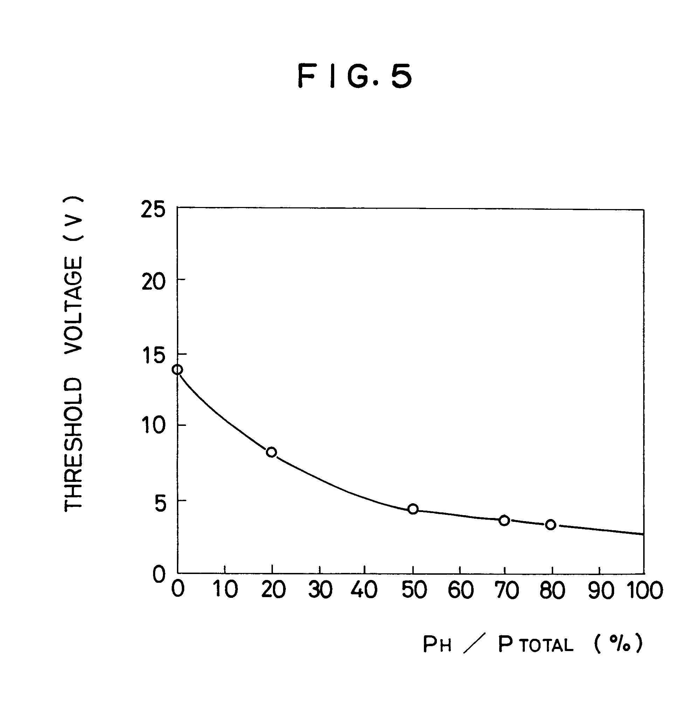

In order to assess the effects of varying impurity densities, the above procedure was repeated with various atmospheres for the deposition of the semiconductor film 33. The deposition was carried out several times and each time the proportion of hydrogen in the hydrogen/Ar mixture atmosphere was changed and took one of these values H$_2$/(H$_2$+Ar) = 0, 0.2, 0.5, 0.7 and 0.8 in terms of partial pressure. The oxygen densities measured in these cases were $2 \times 10^{20}$cm$^{-3}$ (0), $7 \times 10^{19}$cm$^{-3}$ (0.2), $3 \times 10^{19}$cm$^{-3}$ (0.5), $1 \times 10^{19}$ cm$^{-3}$ (0.7) and $8 \times 10^{-18}$cm$^{-3}$ (0.8). Fig. 4 is a graphical diagram showing the field mobility versus the proportion of hydrogen present (P$_H$·P$_{TOTAL}$=H$_2$/(H$_2$+Ar)) plotted using the transistors formed in the respective cases. In accordance with this graph higher values of field mobility can be attained by a higher P$_H$/P$_{TOTAL}$. The mobility ($\mu$) was as low as $3 \times 10^{-1}$ cm$^2$/Vsec when the hydrogen proportion was 0% since the oxygen density in this case is as high as $2 \times 10^{20}$cm$^{-3}$. Conversely, the mobility was limited to a minimum of 2 cm$^2$/Vsec as long as the hydrogen proportion was no lower than 20% (corresponding to a maximum oxygen density of $7 \times 10^{19}$cm$^{-3}$ as seen from Fig. 4. This increase in mobility is due in part to the introduction of hydrogen which makes it possible to convert oxygen occurring in the deposition space to water which in turn can be effectively removed from the deposition space by means of the cryosorption pump. Fig. 5 is a graphical diagram showing the threshold voltage versus the hydrogen proportion. As shown from this diagram, field effect transistors of normally off type can be formed having a maximum threshold voltage of 8 V, which is desirable from a practical view point, as long as the hydrogen proportion is no lower than 20%. Low threshold voltages correspond to low gate voltages of field effect transistors. This means that transistors having good characteristics can be formed by fabricating channel regions formed by depositing amorphous silicon films through sputtering carried out in a hydrogen atmosphere and giving the films thermal treatment in accordance with the present invention using an atmosphere with the appropriate hydrogen proportion. The electrical characteristics tend to be improved as the hydrogen proportion is increased.

To assess the effects of $H_2$ proportion on crystallinity in the deposited channel region, only the 0.0, 0.2 and 0.5 ratios of $H_2/(H_2+Ar)$ atmospheres were used. Fig. 6 is a graphical diagram showing Raman spectra of the resultant semiconductor films 33 plotted after the thermal treatment. The proportions of hydrogen in the hydrogen/Ar atmosphere, i.e. $H_2/(H_2+Ar)$, were 0 (curve 61), 0.2 (curve 62) and 0.5 (curve 63) in terms of partial pressure and the relative intensity of the Raman spectra related to the crystallinity of each atmosphere. As shown in the diagram, the crystallinity was significantly enhanced when the hydrogen proportion was increased to 20% (curve 62) as compared with the case of 0% (curve 61). The average grain diameter of constituent crystals of the film formed in the 20% hydrogen atmosphere was in the range 5Å to 400Å, typically between 50Å and 300Å. The peak position of the Raman spectra was located at a smaller wave number than the peak spectral position of single crystalline silicon, i.e. 520cm$^{-1}$, which indicated the existence of lattice distortion. The lattice distortion functions to lessen change in a crystalline structure at the interfaces between constituent crystals so that each crystal can be more closely connected with its neighbours and fewer impurities such as oxygen are collected at the interfaces, thereby lowering the barrier heights between crystals. As a result, high carrier mobilities can be realized.

The figures of grain diameters presented herein were calculated on the basis of Raman spectra measured by Raman spectra analysis. It is, however, not certain whether or not separate grains actually exist in the semiconductor films. Rather, definite grains do possibly not exist so that the figures might be nominal. The nominal grain diameter can be controlled by adjusting the input RF power or the strength of magnetic fields applied to the substrate to be coated during deposition. The semiconductor can be deposited with a larger average grain diameter when an increased electric current is supplied to the electromagnet 13b (Fig. 2(B)) in order to induce a stronger magnetic field. If the current is reduced, the grain diameter can be decreased.

Next, the mechanism for the formation of semi-amorphous or semi-crystalline semiconductor material in accordance with the present invention will be explained. When sputtering a single crystalline silicon target in a mixture of hydrogen and argon, high-energy heavy argon atoms collide with the surface of the target and dislodge therefrom clusters each containing several tens to several hundreds of thousands of silicon atoms, which are finally deposited on the substrate to be coated. These clusters pass through the mixture of gases in advance of their deposition on the substrate and react with hydrogen atoms at their external surfaces in order to terminate their dangling bonds. Accordingly, when deposited on the substrate, the clusters comprise internal amorphous silicon and external ordered silicon including Si-H bonds. The Si-H bonds react with other Si-H bonds and are converted to Si-Si bonds by thermal treatment in the temperature range 450°C to 700°C or irradiation with a beam emitted from a light source, for example a laser or a halogen lamp, or the like in a non-oxidizing atmosphere. This coupling of adjacent silicon atoms (Si-Si) functions to let adjacent clusters be attracted to each other whereas without thermal treatment or exposure to light these clusters have a tendency to convert their states to more ordered states (partial recrystallization). As a result of adjacent combinations, the crystalline structure of these clusters is given lattice distortion and the peak of its Raman spectra is displaced in the low-frequency direction.

The energy bands of the clusters are connected through the Si-Si bonds thereby anchoring the clusters at the interfaces therebetween. For this reason, the polycrystalline (semi-amorphous or semi-crystalline) structure of silicon in accordance with the present invention is entirely different from usual polycrystals in which grain boundaries provide barriers against carrier transportation, so that the carrier mobility of the polycrystalline silicon can be of the order of 10 to 200 cm$^2$/Vsec. Therefore, the semi-amorphous or semi-crystalline structure in accordance with the present invention can be considered substantially not to include undesirable grain boundaries. However, if the semiconductor is subjected to high temperatures of 1000°C or higher rather than the relatively low temperatures of 450°C to 700°C, latent oxygen atoms can come to appear at the boundaries between the clusters and form barriers as in some of the prior art techniques. The carrier mobility can be improved by increasing the strength of the anchoring between the clusters. For this purpose, the oxygen density in the semiconductor film is decreased to a maximum of $7 \times 10^{19}$cm$^{-3}$, desirably to a maximum of $1 \times 10^{19}$cm$^{-3}$, so that recrystallization can be carried out at temperatures no higher than 600°C.

The following data demonstrates the effects of varying the proportion of hydrogen used for deposition in the present invention:

| $H_2$ proportion | S | VT | $\mu$ | on/off ratio |
|---|---|---|---|---|
| 0 | 3.1 | 13.8 | 0.3 | 5.4 |
| 20 | 2.4 | 8.3 | 2.4 | 6.7 |
| 50 | 2.0 | 4.5 | 10.1 | 6.9 |
| 70 | 1.7 | 3.8 | 22.3 | 6.9 |
| 80 | 0.97 | 3.5 | 40.4 | 6.2 |

In the above data, $H_2$ proportion is the hydrogen proportion as discussed hereinbefore. S is the minimum value of $[d(ID)/d(VG)]^{-1}$ of the drain current ID as a function of the gate voltage VG in the vicinity of the origin. A smaller S value indicates a sharper rise of the VG-ID characteristic curve and more desirable electric characteristics of the transistor. VT is the threshold voltage. The "$\mu$" is the carrier mobility in units of $cm^2/V \cdot s$. The "on/off ratio" is the logarithm of the ratio of the drain current ID with VG being at 30V to the minimum value of the drain current ID when the drain voltage is fixed at 10V. From the data, it can be seen that an atmosphere with an 80% or more proportion of hydrogen gives the most desirable results.

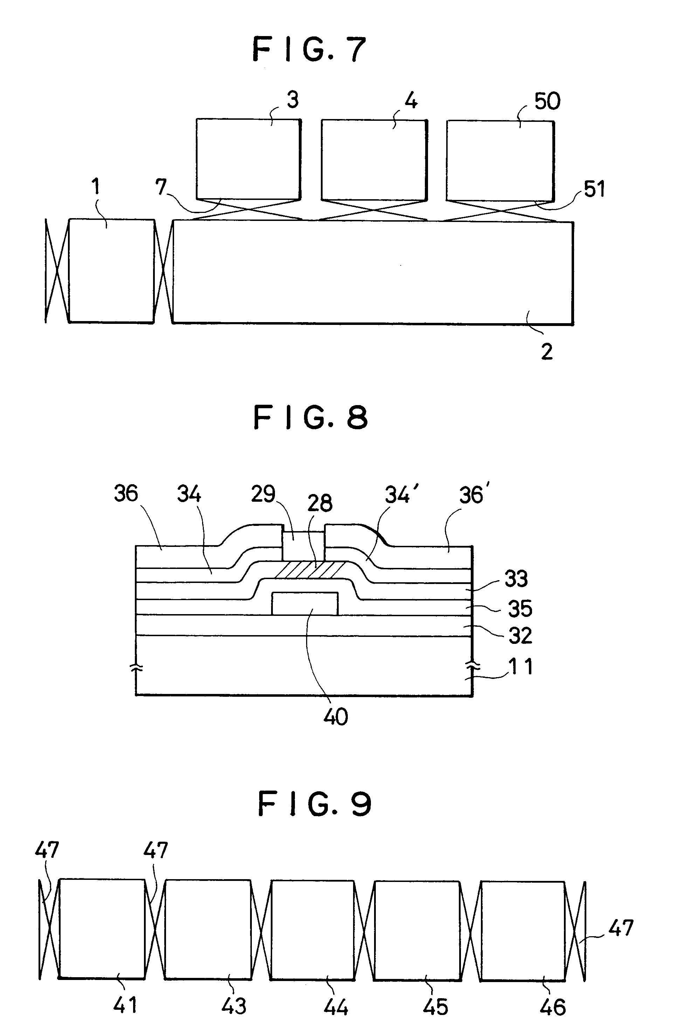

Referring to Fig. 8, a method of manufacturing thin-film field effect transistors in accordance with a second preferred embodiment of the present invention will now be illustrated. This method is carried out by means of a system illustrated in Fig. 7 which as compared to Fig. 1 is provided with an additional third sputtering apparatus 50 connected to the subsidiary chamber 2 by a valve 51. The other elements are substantially the same as the corresponding elements illustrated in Fig. 1. The deposition of the insulating film 32 is carried out in the same manner as the first embodiment. However, a gate electrode 40 is then formed by depositing and patterning a 3000Å thick molybdenum film unlike the procedure of the first embodiment.

The entire surface of the structure is then coated with a silicon oxide film 35 to a thickness of 100 nm by magnetron RF sputtering in the first sputtering apparatus 3. The conditions under which deposition is carried out are given as: an atmosphere comprising high density oxygen possibly diluted with an inert gas, but preferably 100% oxygen at a total atmospheric pressure of 0.5 Pa; a power output of 400W from the 13.56 MHz RF apparatus; a target composed of an artificial quartz or a high purity silicon, for example, a single crystalline silicon or a polycrystalline silicon, having a purity of 99.999% or more; and a substrate temperature of 100°C. When pure oxygen (100% oxygen) is used as the atmosphere, the surface level density of the gate insulating film is decreased thereby producing excellent transistor characteristics.

An amorphous silicon film 33 is deposited on the silicon oxide film 35 to a thickness of 100 nm in the second sputtering apparatus 4. The atmosphere comprises a mixture consisting of hydrogen and argon so that the partial pressure of hydrogen is given as $H_2/(H_2+Ar) = 0.8$. The deposition is carried out under a total atmospheric pressure of 0.5 Pa with the output power of the 13.56 MHz RF apparatus at 400W using a target composed of single crystalline silicon and a substrate temperature of 150°C in the same manner as described hereinbefore. The amorphous silicon film is then given thermal treatment in the subsidiary chamber 2 at a temperature in the range 450°C to 700°C (typically 600°C) for 10 hours in a hydrogen or an inert atmosphere, e.g. in 100% nitrogen. The film is recrystallized by this treatment to become polycrystalline. In accordance with these processes, it has been confirmed by SIMS analysis that oxygen, carbon and hydrogen atoms were involved respectively at $1 \times 10^{19} cm^{-3}$, $4 \times 10^{18} cm^{-3}$ and no higher than 1%. These density figures were minimum values of the respective elements which varied along the depth direction. Thus, a channel region 28 is formed on the gate electrode 40 with the gate insulating film 35 in between.

In the next step, an $n^+$-type amorphous silicon semiconductor film is deposited on the film 33 to a thickness of 50 nm in the third magnetron RF sputtering apparatus 50. The conditions under which deposition is carried out are given as: an atmosphere comprising $H_2$ at 10% to 99%, (typically 80%) and Ar at 1% to 90%, (typically 19%) at a total atmospheric pressure of 0.5 Pa; a power output of 400W from the 13.56 MHz RF apparatus; a target composed of a single crystalline silicon doped with phosphorus; and a substrate temperature of 150°C. The entire surface of the structure is coated with an aluminum film. The $n^+$- type film and the aluminum film are patterned to form source and drain regions 34 and 34' and source and drain electrodes 36 and 36' respectively. The channel region 28 is defined just below a gap between the source and the drain regions 34 and 34'. The gap is filled with an insulator 29 for protecting the channel region 28.

In accordance with the second embodiment, since the gate insulating film 35 is formed in advance of the formation of the semiconductor film 33 forming the channel 28, the interface between the insulating film 35 and the channel 28 is readily thermally annealed so that the density of surface levels can be decreased. The oxygen density in the semiconductor film 33 and the mobility were measured to be $1 \times 10^{19} cm^{-3}$ and $40.8 cm^2/Vsec$ respectively.

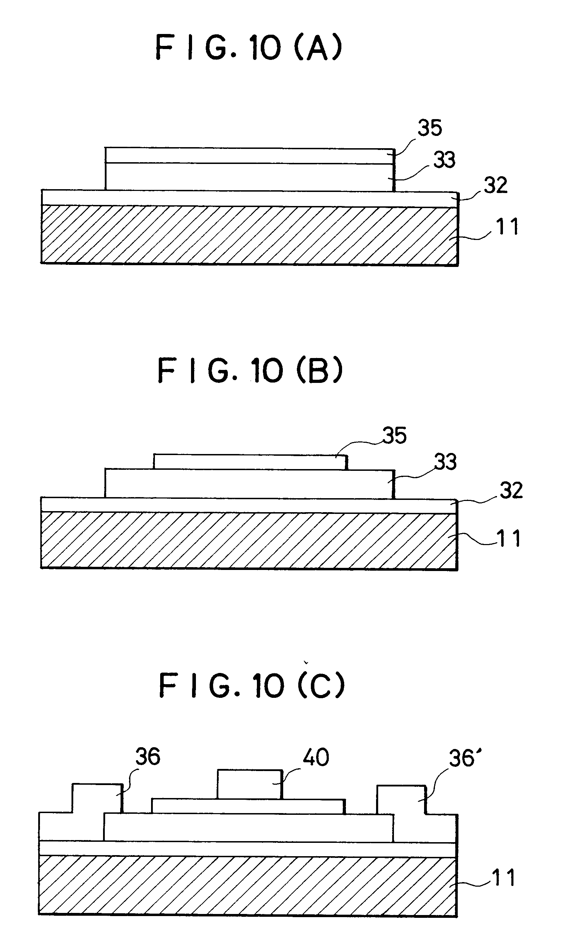

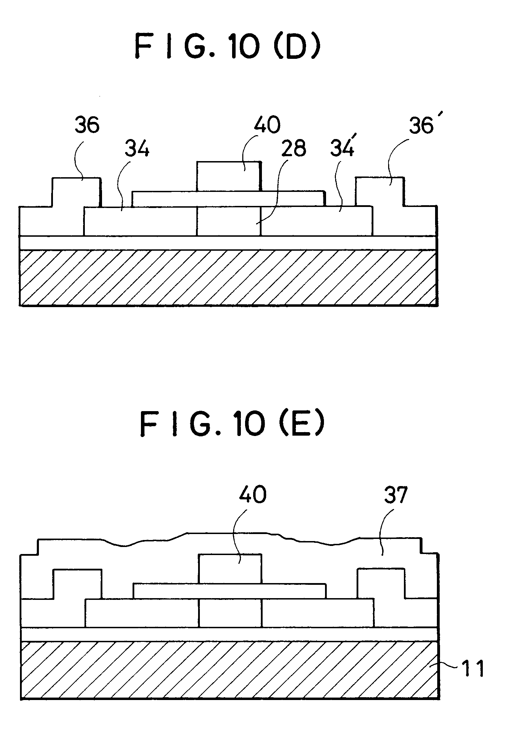

Referring to Fig. 9 and Figs. 10(A) to 10(E), a method of manufacturing gate insulated field effect transistors in accordance with a third embodiment of the present invention will be explained. Fig. 9 is a schematic view showing a multi-chamber sputtering system for depositing semiconductor and oxide films by magnetron RF sputtering. The system comprises a loading chamber 41, first, second and third individual sputtering apparatuses 43, 44 and 45 and an unloading chamber 46. These chambers and sputtering apparatuses are connected in series via gate valves 47 respectively. The structure of the loading chamber 41 and the unloading chamber 46 are substantially the same as the loading and unloading chamber 1 of the first embodiment and will therefore not be described. Also, the structures of the sputtering apparatuses 43, 44 and 45 are the same as illustrated in Figs. 2(A) and 2(B) which have been explained in detail previously.

The sputtering apparatuses 43 and 45 are individual planar type magnetron RF sputtering apparatuses dedicated for use in depositing oxide films, and the intermediate sputtering apparatus 44, is dedicated for use in depositing semiconductor films when used in accordance with this embodiment.

Referring to Figs. 10(A) to 10(E) together with Fig. 9, the procedure of manufacturing thin-film field effect transistors in accordance with the third preferred embodiment of the invention will now be described in detail.

Ten sheets of glass substrate are mounted on a cassette and placed in the loading chamber 41 via the valve 47. After adjusting the pressures and inner atmospheres of the loading chamber 41 and the first sputtering apparatus 43 to be equivalent, one of the glass substrates is transported to and positioned in the first sputtering apparatus 43 as shown in Fig. 2(A) by means of a transportation mechanism (not shown) and coated with a $SiO_2$ film 32 therein to a thickness of 200nm. The conditions under which this deposition is carried out are given as: an atmosphere of 100% oxygen; a total atmospheric pressure of 0.5 PA; a substrate temperature of 150°C and a power output of 400W from the 13.56 MHz RF apparatus. A target composed of an artificial quartz or a high purity silicon, for example a single crystalline silicon or a polycrystalline silicon, having a purity of 99.999% or more. During deposition, a halogen may be introduced into the oxide film 32 if desired in order to effectively prevent alkali metal atoms from getting into the film from the glass substrate.

The substrate is then coated with an amorphous silicon film 33 to a thickness of 100 nm in the second sputtering apparatus 44. The atmosphere in the second sputtering apparatus 44 consists of hydrogen and argon so that the partial pressure of hydrogen is given as $H_2/(H_2+Ar)=0.8$. The hydrogen and argon gases have purities of 99.999% and 99.99% respectively and are introduced after the inside of the second sputtering apparatus 44 is evacuated to a pressure of $1 \times 10^{-7}$ Pa. The deposition is carried out under a total atmospheric pressure of 0.5 Pa with the output power of the 13.56 MHz RF apparatus at 400W using a target composed of single crystalline silicon containing oxygen atoms at a concentration of no higher than $5 \times 10^{18} cm^{-3}$ (typically $1 \times 10^{18} cm^{-3}$) and with the substrate temperature (deposition temperature) maintained at 150°C by use of the heater 16a as hereinbefore described.

The substrate is then transported into the third sputtering apparatus 45 and this is followed by hydrogen plasma cleaning of the surface of the semiconductor film 33 therein. The entire structure is then coated with a 100 nm thick silicon oxide film 35 in an oxide atmosphere. The conditions under which deposition is carried out are given as: an atmosphere comprising oxygen (95%) and $NF_3$ (5%) at a total atmospheric pressure of 0.5 Pa; a power output of 400W from the 13.56 MHz RF apparatus; a target composed of an artificial quartz or a high purity silicon, for example a single crystalline silicon or a polycrystalline silicon, having a purity of 99.999% or more and a substrate temperature of 100°C. By this procedure, the silicon oxide film 35 which constitutes the gate insulating film includes fluoride atoms which function to terminate dangling bonds of silicon atoms so that the formation of fixed charge can be prevented at the interface between the semiconductor film 33 and the oxide film 35.

The above explanation of the third embodiment has followed the successive treatment of one substrate. In a manufacturing process, however, the process is carried out using a pipeline methodology. Each sputtering apparatus receives the next substrate when a preceding substrate is coated and transported to the next right sputtering apparatus or to the unloading chamber 46, and carried out deposition on the next substrate concurrently with the other apparatuses unless deposition on all the 10 substrates has been finished. The transportation of each substrate between any adjacent chambers is carried out after adjusting the pressures and the inner atmospheres of the adjacent chambers in order to eliminate undesirable impurities as explained previously.

After all the substrates are coated with the silicon oxide and amorphous silicon semiconductor film 32, 33 and 35 and collected in the unloading chamber 46, thermal treatment by means of a heater provided in the chamber, is given thereto at a temperature of 450°C to 700°C (typically 600°C) for 10 hours in a hydrogen or an inert atmosphere, e.g. in 100% nitrogen. The semiconductor film 33 is recrystallized by this treatment (thermal annealing) and forms a semi-amorphous or semi-crystalline structure. It was confirmed by SIMS that oxygen, carbon and hydrogen were present in this structure at densities of $8 \times 10^{18} cm^{-3}$, $3 \times 10^{16} cm^{-3}$ and $4 \times 10^{20} cm^{-3}$ respectively, which are in total equivalent to one atom % assuming the density of silicon to be $4 \times$

$10^{22}cm^{-3}$. These density figures were minimum values for the respective elements which varied along the depth direction as in the case of the first embodiment. The evaluation of these densities should be also made with reference to the oxygen density in the silicon target ($1 \times 10^{18}cm^{-3}$). The semiconductor film 33 may be recrystallized by exposing the film 33 to a beam emitted from a light source, for example a laser or halogen lamp.

These impurity densities were not changed even after the recrystallization so that the oxygen density remained at $8 \times 10^{18}cm^{-3}$. The formation of amorphous silicon films was repeated for reference by introduction of $N_2O$ with the reactive gas at 2 rates: 0.1 cc/sec and 1 cc/sec. As a result, the oxygen densities after recrystallization increased to $1 \times 10^{20}cm^{-3}$ and $4 \times 10^{20}cm^{-3}$ respectively. In these cases, the temperature during thermal annealing must be elevated beyond 700°C or the time of thermal treatment must be increased by a factor of 5 to perform sufficient recrystallization. Such high temperatures cannot be employed in practice because of the low softening temperature of glass substrates. Also, long process times are undesirable from the view point of mass-production. These facts highlight the importance of the present invention. The recrystallization of such amorphous silicon semiconductor films is not possible as a practical matter, however, when the thermal annealing was carried out at no higher than 450°C or the oxygen density in the amorphous silicon semiconductor films reach $1 \times 10^{20}cm^{-3}$ or higher due to oxygen leakage into the system. Therefore, the oxygen density in the semiconductor films and the temperature range of thermal annealing have to be no higher than $7 \times 10^{19}cm^{-3}$ and in the range of 450°C to 700°C respectively. In the case of the semiconductor film formed according to the present invention, however, lattice distortion prevents the formation of barriers. The existence of lattice distortion was indicated by a shift in a peak of laser Raman spectra towards the lower frequency direction.

After recrystallization, the substrates are removed from the system. The oxide and semiconductor films 33 and 35 of each substrate are etched in a suitable etching apparatus to produce a pattern necessary to form a number of transistors on the substrate 11 in accordance with the following procedure. The remaining parts of the films 33 and 35 shown in Fig. 10(A) correspond to one of the transistors to be formed. The oxide film 35 is etched again in order to provide access to the source and drain regions which will be formed within the semiconductor film 33 in the latter stages of this process. A silicon semiconductor film which is highly doped with phosphorus is deposited on the patterned structure by low-pressure CVD and this is followed by photolithography with a suitable mask in order to form a gate electrode 40 and source and drain electrodes 36 and 36' as illustrated in Fig. 10(C).

Using this mask or with the gate electrode 40 as a mask, self-aligned impurity regions, i.e. a source and a drain region 34 and 34' are formed by ion implantation followed by thermal annealing at 100°C to 500°C, for example 300°C, for 0.1 hour to 3 hours, for example 1 hour, in a hydrogen atmosphere. The intermediate region 28 of the silicon semiconductor film 33 between the impurity regions 34 and 34' is defined as a channel region as illustrated in Fig. 10(D) and the resultant interface state density is not more than $2 \times 10^{11}cm^{-3}$. An insulating passivation film 37 is coated over the entire surface of the structure. In accordance with this embodiment, the throughput of manufacture can be substantially increased since all the sputtering apparatuses can operate in parallel.

The foregoing description of preferred embodiments has been presented for purposes of illustration and description. It is not intended to be exhaustive or to limit the invention to the precise form described, and obviously many modifications and variations are possible without departure from the scope of the invention. The embodiments were chosen in order to explain most clearly the principles of the invention and its practical applications thereby enabling others in the art to utilize most effectively the invention in various embodiments and with various modifications as are suited to the particular use contemplated. Examples are as follows:

The present invention can be applied to transistors utilizing other types of semiconductors such as germanium or silicon/germanium ($Si_xGe_{1-x}$) in which case the thermal treatment can be done at temperatures approximately 100°C lower than those used in the above embodiments. The deposition of such semiconductors can be carried out by sputtering in a high-energy hydrogen plasma caused by optical energy (shorter than 1000nm wavelength) or electron cyclotron resonance (ECR). In this case, positive ions can be effectively produced so that the formation of a microstructure in the semiconductor film thus deposited is further prevented. Instead of gases including hydrogen molecules, some hydrogen compounds can be used as the atmosphere for sputtering as long as they do not produce additional impurities. For example, monosilane or disilane may be used for forming silicon semiconductor transistors. Although in the preferred embodiments, oxide and semiconductor films are deposited in separate apparatuses, it is also within the scope of this patent to deposit other types of gate insulating films or gate electrodes in a separate apparatus which is intended for exclusive use in depositing semiconductor films. Such a gate electrode may be produced in the form of either a single layer or a multi-layer. In the case of the single layer, the gate electrode may be a silicon electrode doped with phosphorus or an aluminum electrode. In the case of the multi-layer, the gate electrode may be a two-layer electrode which consists of a lower chromium layer and an upper aluminum layer formed thereon or a two-layer electrode which consists of a lower silicon layer doped with phosphorus and an upper metallic or metal silicide layer for-

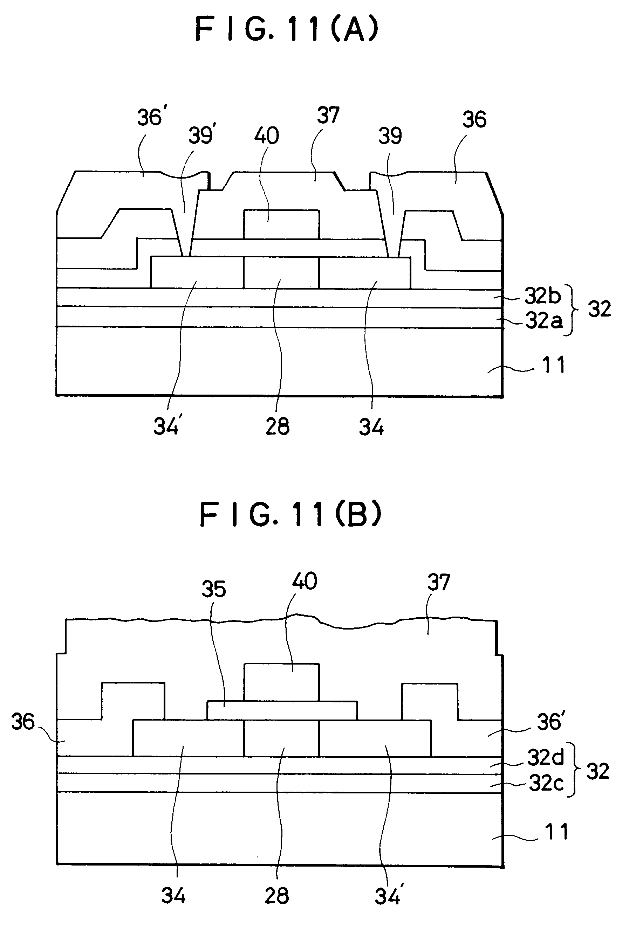

med thereon. The aluminum single layer electrode and the upper aluminum layer can be formed by sputtering an aluminum target. The silicon single layer electrode and the lower silicon layer can be formed by using low-pressure CVD in accordance with the first preferred embodiment or by sputtering a silicon target doped with phosphorus. The lower chromium layer can be formed by sputtering a chromium target. The metallic layer may be a molybdenum layer formed by sputtering a molybdenum target, a wolfram layer formed by sputtering a wolfram target, a titanium layer formed by sputtering a titanium target, or an aluminum layer formed by sputtering an aluminum target. The metal silicide layer may be a $MoSi_2$ layer formed by sputtering a $MoSi_2$ target, a $WSi_2$ layer formed by sputtering a $WSi_2$ target, or a $TiSi_2$ layer formed by sputtering a $TiSi_2$ target. The metallic or metal silicide layer can be formed in the magnetron RF sputtering apparatus shown in Fig. 2(A). The formation of the metallic or metal silicide layer may be carried out in a pipeline process for making gate insulated field effect transistors in a multi-chamber apparatus comprising individual sputtering apparatuses arranged in series. The formation of the silicon single layer electrode, the aluminum single layer electrode, the lower silicon layer, the lower chromium layer, and the upper aluminum layer may also be carried out in such a pipeline process. In this process, the upper metallic or metal silicide layer is formed in a sputtering apparatus different from a sputtering apparatus in which the lower silicon layer is formed and the upper metallic or metal silicide layer may be formed either before or after the formation of the lower silicon layer. In the pipeline process, the upper aluminum layer is formed in a sputtering apparatus different from a sputtering apparatus in which the lower chromium layer is formed and the upper aluminum layer may be formed either before or after the formation of the lower chromium layer. In the preceding preferred embodiments a $SiO_2$ single-layer film is used as a gate insulating film, however, a $Si_3N_4$ single-layer film or a multi-layer film comprising a $SiO_2$ layer and a $Si_3N_4$ layer may be used as a gate insulating film formed in such a pipeline process as described above. In the case of this multi-layer film, one of the $SiO_2$ or $Si_3N_4$ layers is formed by sputtering in a first sputtering apparatus and the other is formed by sputtering in a second sputtering apparatus. The $Si_3N_4$ single-layer film and the $Si_3N_4$ layer can be formed by sputtering a $Si_3N_4$ target. The $SiO_2$ single-layer film can be formed by sputtering an artificial quartz target or a high purity silicon target, for example a single crystalline silicon target or a polycrystalline silicon target, having a purity of 99.999% or more. In place of the $SiO_2$ film 32 shown in Fig. 3(A) a $SiO_2$ film doped with phosphorus or a halogen element, for example fluorine, at a concentration in the range of $5 \times 10^{19} cm^{-3}$ to $5 \times 10^{21} cm^{-3}$ may be deposited on a substrate in order to neutralize alkali ions, for example sodium ions, which have diffused from the substrate into this film. The $SiO_2$ film doped with fluorine may be deposited on a substrate by sputtering an artificial quartz target or a high purity silicon target, for example a single crystalline silicon target or a polycrystalline silicon target, having a purity of 99.999% or more in an atmosphere comprising $NF_3$ gas and oxygen. The $SiO_2$ film doped with phosphorus may be deposited on a substrate by sputtering an artificial quartz target or a high purity silicon target, for example a single crystalline silicon target or a polycrystalline silicon target, having a purity of 99.999% or more in an atmosphere comprising $PH_3$ or $PF_3$ in addition to oxygen. The $SiO_2$ single-layer film doped with phosphorus or a halogen element may be used as a gate-insulating film. Alternatively a multi-layer $SiO_2$ film 32 comprising a $SiO_2$ layer 32a doped with phosphorus or a halogen element and a non-dope $SiO_2$ layer 32b formed thereon as shown in Fig.11 (A) or a multi-layer $SiO_2$ film 32 comprising a non-dope $SiO_2$ layer 32c and a $SiO_2$ layer 32d doped with phosphorus or a halogen element and formed thereon as shown in Fig. 11(B) may be formed on a substrate 31.

In the preceding description a thermal treatment is used to anneal an amorphous semiconductor film, however, optical energy may be used to anneal an amorphous semiconductor film.

In the first preferred embodiment it is indicated from Fig. 5 that the electric characteristics of the transistors whose semiconductor films 33 are obtained by depositing an amorphous semiconductor film by sputtering in an atmosphere comprising hydrogen, oxygen and argon and subsequently by thermal annealing the amorphous semiconductor film tend to be improved as the hydrogen proportion of the atmosphere is increased. Also electric characteristics of transistors whose semiconductor films (channel regions) are obtained by depositing amorphous semiconductor films by sputtering in an atmosphere comprising hydrogen, oxygen and argon and subsequently by optically annealing these amorphous semiconductor films (channel regions) by exposure to a light source, for example a laser or a halogen lamp, tend to be improved as the hydrogen proportion of the atmosphere is increased.

## Claims

1. A method of manufacturing field effect transistors comprising source and drain semiconductor regions, a channel region between said source and drain regions, and a gate electrode formed on said channel region through a gate insulating film, said method including:

   depositing one of an oxide film and a semiconductor film on a substrate by sputtering in a first sputtering apparatus;

transporting said substrate from said first apparatus to a second sputtering apparatus; and

depositing the other of said oxide and semiconductor films on said substrate by sputtering in the second sputtering apparatus;

the deposition of said oxide film being carried out in an atmosphere comprising oxygen and the deposition of said semiconductor film being carried out in an atmosphere comprising hydrogen.

2. The method of claim 1 wherein said transportation is carried out through a gate valve connecting said first and second apparatuses after adjusting the pressures and the inner atmospheres of said first and second apparatuses in order to eliminate undesirable impurities.

3. The method of claim 1 or 2 further including the deposition of a third film made of oxide in one of the first and second apparatuses in which deposition of said oxide film has been carried out.

4. The method of claim 1 or 2 further including the deposition of a third film made of oxide in a third apparatus connected with one of said first and second apparatuses through a gate valve.

5. A method of manufacturing field effect transistors comprising:

depositing a semiconductor film on an insulating surface by sputtering in an atmosphere comprising hydrogen in a first sputtering apparatus;

depositing an oxide film on said semiconductor film by sputtering in an atmosphere comprising oxygen in a second sputtering apparatus;

forming a gate electrode on said semiconductor film with said oxide film insulating said semiconductor film from said gate electrode in order to define a channel region in said semiconductor film just below said gate electrode; and

forming source and drain semiconductor regions adjacent to said channel region.

6. The method of claim 5 wherein said drain and source regions are formed by implanting ions into said semiconductor film with said gate electrode employed as a mask.

7. A method of manufacturing field effect transistors comprising:

forming a gate electrode on an insulating surface;

depositing an oxide insulating film on said gate electrode by sputtering in an atmosphere comprising oxygen in a first sputtering apparatus to form a channel region in said semiconductor film just above said gate electrode; and

forming source and drain semiconductor regions adjacent to said channel region.

8. A method of manufacturing field effect transistors comprising:

depositing a silicon dioxide film on a substrate by sputtering in an atmosphere comprising oxygen in a first sputtering apparatus; and

depositing a semiconductor film on said silicon dioxide film by sputtering in an atmosphere comprising hydrogen in a second sputtering apparatus.

9. A method of manufacturing field effect transistors comprising:

depositing a semiconductor film on an insulating surface by sputtering in an atmosphere comprising hydrogen in a first sputtering apparatus; and

depositing a gate oxide film on said semiconductor film by sputtering in an atmosphere comprising oxygen in a second sputtering apparatus.

10. A method of manufacturing field effect transistors comprising:

depositing a gate oxide film on a semiconductor film by sputtering in an atmosphere comprising oxygen in a first sputtering apparatus;

transporting said gate oxide film from said first sputtering apparatus into a second sputtering apparatus without exposing said gate oxide film to air; and

forming a gate electrode on said gate oxide film by sputtering in said second sputtering apparatus.

11. A method of manufacturing field effect transistors comprising:

depositing a silicon dioxide film on a substrate by sputtering in an atmosphere comprising oxygen in a first sputtering apparatus;

depositing a semiconductor film on said silicon dioxide film by sputtering in an atmosphere comprising hydrogen in a second sputtering apparatus; and

depositing a gate insulating film on said semiconductor film by sputtering in a third sputtering apparatus.

12. A method of manufacturing field effect transistors comprising:

depositing a silicon dioxide film on a substrate by sputtering in an atmosphere comprising oxygen in a first sputtering apparatus;

depositing a semiconductor film on said silicon dioxide film by sputtering in an atmosphere comprising hydrogen in a second sputtering apparatus; and

depositing a gate oxide film on said semiconductor film by sputtering in an atmosphere comprising oxygen in said first sputtering apparatus.

13. A method of manufacturing field effect transistors comprising:

depositing a semiconductor film on an insulating surface by sputtering in an atmosphere comprising hydrogen in a first sputtering apparatus;

depositing a gate oxide film on said semiconductor film by sputtering in an atmosphere comprising oxygen in a second sputtering apparatus; and

forming a gate electrode on said gate oxide film by sputtering in a third sputtering apparatus.

14. A method of manufacturing field effect transistors comprising:

depositing a semiconductor film on an insulating surface by sputtering in an atmosphere comprising hydrogen in a first sputtering apparatus;

depositing a gate insulating film on said semiconductor film by sputtering in a second sputtering apparatus.

15. A method of manufacturing field effect transistors comprising:

depositing a gate insulating film on a semiconductor film by sputtering in a first sputtering apparatus;

transporting said gate insulating film from said first sputtering apparatus into a second sputtering apparatus without exposing said gate insulating film to air; and

forming a gate electrode on said gate insulating film by sputtering in said second sputtering apparatus.

16. A method of manufacturing field effect transistors comprising:

depositing a gate insulating film on an insulating surface over a gate electrode provided thereon by sputtering in a first sputtering apparatus; and

depositing a semiconductor film on said gate insulating film by sputtering in an atmosphere comprising hydrogen in a second sputtering apparatus.

17. A method of manufacturing field effect transistors comprising:

depositing a semiconductor film on a gate insulating film by sputtering in an atmosphere comprising hydrogen in a first sputtering apparatus; and

depositing a p-type or n-type semiconductor film on said semiconductor film by sputtering in an atmosphere comprising hydrogen in a second sputtering apparatus.

18. A method of manufacturing field effect transistors comprising:

depositing a gate insulating film on an insulating surface over a gate electrode formed thereon by sputtering in a first sputtering apparatus;

depositing a semiconductor film on said gate insulating film by sputtering in an atmosphere comprising hydrogen in a second sputtering apparatus; and

depositing a p-type or n-type semiconductor film on said semiconductor film by sputtering in an atmosphere comprising hydrogen in a third sputtering apparatus.

19. The method of claim 17 or 18 further comprising:

forming a mask pattern on said p-type or n-type semiconductor film; and

patterning said p-type or n-type semiconductor film into source and drain regions with said mask pattern.

20. The method of any of claims 1 to 6, 8, 9, 11, 12, 13, 14, 16, 17, 18 and 19 wherein said atmosphere comprising hydrogen comprises a mixture of hydrogen and argon.

21. The method of any of the preceding claims wherein said semiconductor comprises a silicon semiconductor.

# F I G. 1

# F I G. 2 (A)

# F I G. 2 (B)

# FIG. 3(A)

33
32
11

# FIG. 3(B)

40
35

# FIG. 3(C)

34′  40  28  34  37  35
32
11

# FIG. 3(D)

36′  39′  40  37  39  36
38

# F I G. 4

# F I G. 5

# F I G. 6

# FIG. 7

3    4    50

1    7    51

2

# FIG. 8

36    34    29    28    34'    36'

33
35
32
11

40

# FIG. 9

47    47

47

41    43    44    45    46

# F I G. 10 (A)

# F I G. 10 (B)

# F I G. 10 (C)

# F I G. 10 (D)

# F I G. 10 (E)

EP 0 485 233 A2

# F I G. 11 (A)

# F I G. 11 (B)